# EUROPEAN PATENT SPECIFICATION

(11) **EP 4 335 959 B1**
(45) Date of publication and mention of the grant of the patent: **04.09.2024**
(21) Application number: 23196237.4
(22) Date of filing: 08.09.2023
(51) Int. Cl.: D04B 15/88

(54) **SPLIT TYPE TAKE-UP ROLLER OF TAKE-UP UNIT FOR CIRCULAR KNITTING MACHINE**
GETEILTE AUFNAHMEROLLE FÜR EINE AUFNAHMEEINHEIT FÜR EINE RUNDSTRICKMASCHINE
ROULEAU D'ENROULEMENT DE TYPE FENDU D'UNE UNITÉ D'ENROULEMENT POUR MACHINE À TRICOTER CIRCULAIRE

(30) Priority: 12.09.2022 JP 2022003026 U
(43) Date of publication of application: 13.03.2024
(73) Proprietor: Precision Fukuhara Works, Ltd., Kobe-shi Hyogo 651-2242 (JP)
(72) Inventor: Matsuo, Kenichi, Hyogo, 651-2242 (JP); Nomura, Shunsuke, Hyogo, 651-2242 (JP)
(74) Representative: Hoffmann Eitle

(56) References cited:
- EP-A1- 0 351 511
- EP-A1- 0 493 955
- CN-A- 109 607 325
- JP-A- 2011 011 897
- JP-A- 2011 219 906
- US-A- 4 765 157

## Description

### Technical Field

The present invention relates to a configuration of a take-up roller of a take-up unit collecting knitted fabric manufactured by a knitting unit of a circular knitting machine. The take-up roller winds the knitted fabric thereon in a roll state.

### Background Art

Generally in a circular knitting machine, tubularly knitted fabric manufactured by a knitting unit provided on an upper part of the knitting machine is rolled up by a take-up unit provided on a lower part of the knitting machine so as to be stored. Typically, the take-up unit sends the tubularly knitted fabric downward using a pull roller so that the tubularly knitted fabric is wound on a take-up roller and thus is collected as a roll.

There are various kinds of take-up rollers, and among them, there is a take-up roller having a configuration capable of being split in the middle thereof. Specifically, this type of take-up roller is split in the middle thereof in the longitudinal direction so that the respective split rollers are moved, by motive power, each in the opposite direction along the axis direction of the take-up roller. Thus, a space between the two split rollers is opened/closed. With this configuration, the take-up roller can be removed from a roll of knitted fabric rolled up thereon when the knitting is finished, which leads to easy operations after knitting such as carry-out of the knitted fabric. This split type take-up roller is often used in an auto-doffer type take-up unit that discharges the finished knitted fabric automatically from the inside of the circular knitting machine to the outside, as shown in Patent Document 1.

Meanwhile, when the knitted fabric is rolled up on the take-up roller, the bigger the roll of knitted fabric becomes, the larger the pressure toward the center of the roll becomes due to increase in take-up tension of the knitted fabric and so forth. Sometimes the split type take-up roller is unintentionally split by this pressure, not by the motive power. If the take-up roller is thus split, the accuracy in rolling up is degraded. Also in the case where the split take-up rollers sandwich the knitted fabric as shown in Patent Document 1, sandwiching of the knitted fabric loosens due to the split take-up rollers being separated from each other, which affects the rolling up of the knitted fabric.

In order to prevent the above unintentional split of the take-up roller, an invention is also disclosed, as shown in Patent Document 2, in which the split take-up rollers are mechanically engaged with and connected to each other. JP2011011897A discloses a split-type roller according to the preamble of claim 1. JP2011219906A, EP0493955A1 and US4765157A each discloses discloses a split-type roller but no magnet or magnetic material.

### Prior Art Documents

### Patent Documents

[Patent Document 1] JP-B-H02-006862
[Patent Document 2] JPH0143416Y2

### Summary of the Invention

### Problem to Be Solved by the Invention

However, due to recent development of the knitting machine with high-operation speed, the take-up unit also rotates at high speed, which occasionally causes an unintentional split of the split type take-up roller by centrifugal force. Sometimes, although the above-described pressure toward the center of the roll does not cause a big problem, this centrifugal force constrains the take-up roller to split from each other.

In order to deal with the above problem, by mechanically engaging with and thus connecting to the split rollers of the take-up roller as shown in Patent Document 2, the unintentional split of the take-up roller can be prevented. However, such a take-up unit has a complicated configuration with a number of components. Furthermore, in the case where the take-up unit sandwiches the knitted fabric as shown in Patent Document 1, it is difficult to adopt the configuration in Patent Document 2 in which the split rollers of the take-up roller directly make contact with each other to be mechanically engaged with each other, since the knitted fabric is interposed between the two split rollers of the take-up roller.

An object of the present invention is to provide a split type take-up roller of a take-up unit for a circular knitting machine. The split type take-up roller has a simple configuration which can also be applied to a take-up roller that sandwiches the knitted fabric, so that an unintentional split of the take-up roller due to centrifugal force caused by rotation of the take-up unit is prevented.

### Means for Solving the Problem

A split type take-up roller of a take-up unit for a circular knitting machine according to the present invention is a split type take-up roller of a take-up unit collecting knitted fabric knitted by a knitting unit of a circular knitting machine. The split type take-up roller is horizontally provided, and collects the knitted fabric by rolling up the knitted fabric thereon. The split type take-up roller includes: a first take-up roller and a second take-up roller made by splitting the split type take-up roller in a substantial middle thereof in a longitudinal direction; a first facing part that is a facing part of the first take-up roller so as to face the second take-up roller in a state in which the first take-up roller and the second take-up roller are engaged with each other; a second facing part that is a facing part of the second take-up roller so as to face the first facing part in the state in which the first take-up roller and the second take-up roller are engaged with each other; and a magnet provided on at least one of the first facing part and the second facing part so as to generate magnetic force to act on the other one.

With this configuration, the magnetic force acts on between the first take-up roller and the second take-up roller so as to attract them to each other. That is, the centrifugal force to separate them from each other is negated. The magnet is, for example, a permanent magnet that generates magnetic force. In the state in which the first take-up roller and the second take-up roller are connected to each other without splitting, the magnet is provided on at least one of the first facing part and the second facing part, at a position from which the magnetic force reaches the other one. The magnet may also be built in the facing part, apart from provided on the surface thereof. Thus, the first facing part and the second facing part face each other, and furthermore one of them is provided with the magnet while the other of them is a part (magnetic material) on which the magnetic force by the magnet acts. In this way, the magnet improves the force to connect the first take-up roller and the second take-up roller to each other. Therefore, the unintentional split of the first take-up roller and the second take-up roller due to the centrifugal force is prevented. Also, since no complicated connecting configuration is required, it is possible to reduce costs. Furthermore, since the magnetic force acts even when the knitted fabric or the like is interposed between the first take-up roller and the second take-up roller, this configuration can be applied to the take-up roller that sandwiches the knitted fabric.

It is preferable that the first take-up roller includes a convex part protruding toward the second take-up roller from a dividing surface that passes through a dividing position on an outer circumferential surface of the first take-up roller and the second take-up roller, and that the second take-up roller includes a concave part having a shape to house the convex part therein.

With this configuration, the take-up roller is constituted of the first take-up roller and the second take-up roller in which the convex part of the first take-up roller is fitted into the concave part of the second take-up roller. In this way, the first take-up roller and the second take-up roller are firmly engaged with each other, which prevents deformation of the take-up roller even when external force such as force in the direction perpendicular to the rotational axis of the take-up roller is applied. Thus, the first take-up roller and the second take-up roller can be rotated integrally as one roller having the same axis line as the rotational axis.

It is preferable that the convex part is constituted of at least one columnar member such as a sphere, a column, a cone and a frustum, and that the concave part is constituted of at least one columnar hole having a shape substantially complementarily to the at least one columnar member such that the convex part is inserted into the concave part. The shape of the columnar member also includes: a column; a cylinder; an elliptical column; an elliptical cylinder; a triangular prism; a quadrangular prism; a pentagonal prism; a hexagonal prism; and other polygonal prisms and polygonal tubes. Also, the columnar member may have a shape made by combining a plurality of shapes.

With this configuration, the convex part has a columnar shape such as a column, a cone and a frustum while the concave part is formed to house the convex part therein. Thus, the convex part and the concave part are firmly engaged with each other, and it is possible to prevent the take-up roller from becoming deformed even when the external force acts on the outer surface of the take-up roller.

Also, when using a type of unit in which the knitted fabric is sandwiched between the first take-up roller and the second take-up roller so as to fix the knitted fabric to a take-up roll, the first take-up roller and the second take-up roller are re-engaged with each other after a roll of knitted fabric is discharged from the take-up roller. Then, the knitting machine is rotated to some extent that knitted fabric is knitted down a little before the knitting machine is actually started to knit. After that, the first take-up roller and the second take-up roller are separated from each other to make a gap within the range in which the end of the convex part is not out of the concave part, so that the leading end of knitted fabric is inserted between the first take-up roller and the second take-up roller. Then, the convex part is re-inserted completely into the concave part. Thus, the leading end of the knitted fabric can be sandwiched between the first take-up roller and the second take-up roller without being inserted into the concave part. In other words, the position where the knitted fabric is sandwiched is different from the position where the first take-up roller and the second take-up roller are attracted to each other by the magnetic force. In this way, the knitted fabric can be sandwiched without preventing the engagement of the first take-up roller with the second take-up roller due to the interposition of the knitted fabric, which results in firm connection of the first take-up roller to the second take-up roller. Thus, it is possible to reliably realize auto-doffing, i.e. performing automatically unloading and discharge of a roll of knitted fabric from a machine to the outside without manual work so as to start a next knitting.

It is preferable that, in a state in which the split type take-up roller is not split, the first facing part is disposed on an end of the convex part at the side of the second take-up roller, and the magnet is provided on at least a part of a surface of the second facing part or on a part inside the second facing part.

With this configuration, the first facing part is attracted to the side of the second take-up roller because the magnetic force of the magnet acts on the end of the convex part at the side of the second take-up roller. In this way, the magnetic force acts only after the convex part is completely engaged with the concave part, which means that no magnetic force is generated in the engaging process. Thus, the operation process of the take-up unit is not likely to be affected by, for example, occurrence of attraction of tools such as a wrench to the magnet or function of unnecessary force derived from the magnetic force. Also, since the magnet is not provided on the first facing part, the magnet is not broken even when the convex part collides with somewhere.

### Effect of the Invention

The present invention provides a split type take-up roller of a take-up unit for a circular knitting machine. This split type take-up roller has a configuration in which a first take-up roller and a second take-up roller separated from each other are attracted to each other by magnetic force caused by a magnet, which cancels out separating force caused by centrifugal force and acting on dividing parts of the take-up roller. Thus, the dividing parts are not separated from each other. Also, since the split type take-up roller has a simple configuration compared to a configuration in which the first take-up roller and the second take-up roller are mechanically engaged with each other directly to prevent separation, it is possible to reduce the number of components.

### Brief Description of Drawings

[FIG. 1]

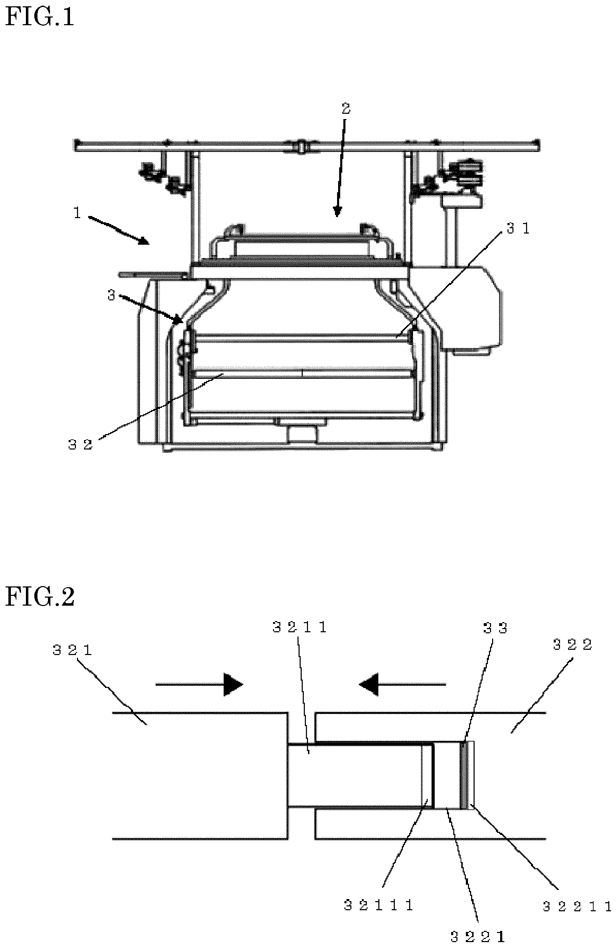

   FIG. 1 is a front view illustrating an entire circular knitting machine including a take-up unit for a circular knitting machine, which has a split type take-up roller of the present invention.
[FIG. 2]
   FIG. 2 is a cross-sectional view illustrating a convex part and a concave part of the split type take-up roller according to embodiment 1 of the present invention.
[FIG. 3]

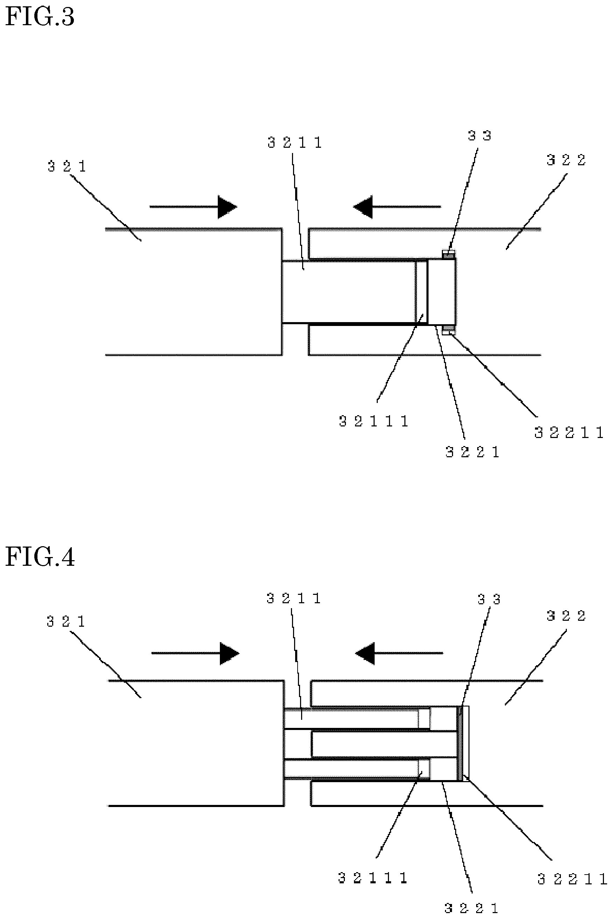

   FIG. 3 is a cross-sectional view illustrating a convex part and a concave part of the split type take-up roller according to embodiment 2 of the present invention.
[FIG. 4]
   FIG. 4 is a cross-sectional view illustrating a convex part and a concave part of the split type take-up roller according to embodiment 3 of the present invention.
[FIG. 5]

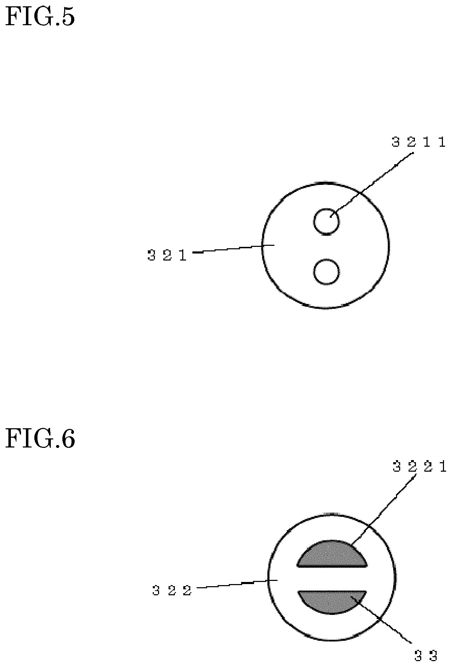

   FIG. 5 is a diagram of a first take-up roller according to embodiment 3 of the present invention, which is viewed from the second take-up roller side.
[FIG. 6]
   FIG. 6 is a diagram of the second take-up roller according to embodiment 3 of the present invention, which is viewed from the first take-up roller side.

### Description of Embodiments

Hereinafter, embodiments of the present invention will be described with reference to the drawings. FIG. 1 is a front view illustrating an entire circular knitting machine 1 including a take-up unit 3 for a circular knitting machine, which has a split type take-up roller of the present invention. Similarly to a general take-up unit for a circular knitting machine, the take-up unit 3 is a unit in which knitted fabric manufactured by a knitting unit 2 provided on an upper part of the circular knitting machine 1 is pulled by a pull roller 31 provided on an upper part of the take-up unit 3 so that the knitted fabric is rolled up on a take-up roller 32 and thus is collected.

The take-up roller 32 has a one columnar shape constituted of a first take-up roller 321 and a second take-up roller 322. An outer circumferential surface of the take-up roller 32 is separable to the first take-up roller 321 and the second take-up roller 322 at an approximately middle part in the longitudinal direction of the take-up roller 32 (i.e. in the horizontal direction when the take-up roller 32 is installed). The outer circumferential surface of the take-up roller 32 is divided at a dividing position along a cross section perpendicular to the rotational axis and to the longitudinal direction.

FIG. 2 is a cross-sectional view illustrating a convex part 3211 and a concave part 3221 of the split type take-up roller 32 according to embodiment 1 of the present invention. A column-shaped convex part protrudes from a dividing surface of the first take-up roller 321 of the take-up roller 32 toward the second take-up roller 322. That is, the first take-up roller 321 has the convex part 3211 that protrudes toward the second take-up roller 322. A first facing part 32111 is disposed on an end of the column-shaped convex part 3211 at the side of the second take-up roller 322. A second facing part 32211 disposed on a bottom end of the concave part of the second take-up roller 322 faces the first facing part 32111. Thus, the flat surface of the first facing part 32111, which is located at the side of the second facing part, faces the flat surface of the second facing part 32211, which is located at the side of the first facing part. A disc-shaped permanent magnet is provided on the second facing part 32211 as a magnet 33. In order to prevent the end of the convex part 3211 from directly making contact with and thus damaging the permanent magnet 33, there is still a small gap of approximately 2 mm between the end of the convex part 3211 and the permanent magnet 33 even when the respective dividing surfaces of the take-up rollers 321 and 322 come into contact with each other. This gap may be larger depending on the strength of the magnet, however, it is preferable to have a gap of at least 0.5 mm for the purpose of preventing the contact with the convex part 3211. The permanent magnet 33 generates force to attract the first facing part 32111 by magnetic force. The strength of the magnetic force of the permanent magnet 33 is set to be necessary and sufficient to negate the centrifugal force that separates the first take-up roller 321 and the second take-up roller 322 when the circular knitting machine 1 is in operation.

In this way, it is possible to cancel and negate the force that is generated by the centrifugal force of the entire take-up unit and that acts on the dividing position of the take-up roller 32 in the opposite direction in the rotational axis direction. Also, the second take-up roller 322 has the concave part 3221 that is a recess having a shape for housing the convex part 3211 so that the convex part 3211 is firmly engaged with the concave part 3221. Thus, even when the force perpendicular to the rotational axis of the take-up roller 32 acts on the take-up roller 32, it is possible to prevent the take-up roller 32 from being bent in the middle thereof or becoming deformed.

When this embodiment is applied to a type of unit in which the leading end of the knitted fabric is sandwiched between the first take-up roller 321 and the second take-up roller 322 so that the knitted fabric is rolled up on a take-up roll by rotating the take-up roller 32, the knitting machine is rotated to some extent that knitted fabric is knitted down a little in the state in which the take-up roller 32 is not divided before the knitting machine is actually started to knit. After that, the first take-up roller 321 and the second take-up roller 322 are separated from each other to make a gap within the range that the end of the convex part is not out of the concave part to exceed the position of the dividing cross section of the take-up roller 32, so that the leading end of knitted fabric is inserted between the first take-up roller 321 and the second take-up roller 322. Then, the convex part 3211 is completely inserted into the concave part 3221. Thus, the knitted fabric can be sandwiched between the first take-up roller 321 and the second take-up roller 322 without being inserted into the concave part 3221. In other words, the position where the knitted fabric is sandwiched is different from the position where the first take-up roller 321 and the second take-up roller 322 are attracted to each other by the magnetic force.

In this way, the knitted fabric can be sandwiched without preventing the engagement of the first take-up roller 321 with the second take-up roller 322 due to the interposition of the knitted fabric. Thus, it is possible to reliably realize auto-doffing, i.e. performing automatically unloading and discharge of a roll of knitted fabric from a machine to the outside without manual work so as to start a next knitting.

FIG. 3 is a cross-sectional view illustrating the convex part 3211 and the concave part 3221 of the split type take-up roller 32 according to embodiment 2 of the present invention. In this embodiment, the convex part 3211 has a shape of a quadrangular prism, and the first facing part 32111 is a side surface of the end part of the quadrangular prism at the side of the second roller 322. The second facing part 32211, which faces the first facing part 32111, surrounds the first facing part 32111. A ring-shaped permanent magnet is provided so as to be an inner surface of the second facing part 32211. In this embodiment, there is no permanent magnet in front of the motion trajectory of the convex part 3211 in contrast to embodiment 1. Thus, the end of the convex part 3211 is not likely to collide with the permanent magnet.

FIG. 4 is a cross-sectional view illustrating the convex part 3211 and the concave part 3221 of the split type take-up roller 32 according to embodiment 3 of the present invention. FIG. 5 is a diagram of the first take-up roller 321 according to embodiment 3 of the present invention, which is viewed from the second take-up roller 322 side. FIG. 6 is a diagram of the second take-up roller 322 according to embodiment 3 of the present invention, which is viewed from the first take-up roller 321 side.

In this embodiment, two column-shaped convex parts 3211 are provided on the dividing surface of the first take-up roller 321 at regular intervals from the center rotational axis of the take-up roller 32. The first facing part 32111 includes a surface of the column-shaped convex part 3211 at the side of the second take-up roller 322. The second facing part 32211 includes a surface that faces the surfaces of the column-shaped convex parts 3211 at the side of the second take-up roller 322. The concave part 3221 has columnar holes each having an inner circumferential surface that comes into contact with the corresponding outer circumferential surface of the two column-shaped convex parts 3211. Between the inner circumferential surfaces, a wall is provided on the center of the hole so as to extend between the two column-shaped convex parts 3211. Thus, the wall comes into contact with the two column-shaped convex parts 3211. The bottom part of this wall is opened, and a disc-shaped permanent magnet is provided on the second facing part 32211 through the opened bottom part of the wall. That is, the disc-shaped permanent magnet covers the surface that faces the surfaces of the two column-shaped convex parts 3211 at the side of the second take-up roller 322. Therefore in this embodiment, the convex part is engaged with and thus positioned relative to the concave part in the rotating direction of the take-up roller 32. In this way, it is possible to prevent deviation of the first take-up roller 321 and the second take-up roller 322 from each other in the rotating direction due to the force caused by rotation of the take-up roller 32.

The present invention is not limited to the above embodiments but only by the scope of the claims. That is, the take-up roller 32 is rotated by the motive power caused by the motor in the above embodiments, however, the take-up roller 32 may be used to other types of take-up units, which include a friction type take-up unit in which a friction roller is rotated in place of the take-up roller 32 and this friction roller comes into contact with the knitted fabric rolled up on the take-up roller 32 so as to rotate, by rotational friction, the take-up roller 32 with the knitted fabric being rolled up thereon.

Also, the take-up roller and the convex part 3211 are not needed to have a columnar shape. They may have any other shapes such as a cylinder, a sphere, a pillar, a cone and a frustum. The convex part 3211 is not necessarily required, and the dividing surface may be a simple vertical cross-section or the like. Also, the dividing surface between the first take-up roller 321 and the second take-up roller 322 is not limited to be the vertical cross-section. It may have any other shape such as an inclined cross-section and a wavy cross-section provided that the first take-up roller 321 and the second take-up roller 322 are engaged with each other. Also, the whole dividing surface is not required to serve as an engaging surface. Parts of the dividing surface may serve as engaging surfaces. Furthermore, the magnet 33 is not necessarily required to be a permanent magnet. It may be, for example, an electromagnet. The kind of the magnet is not particularly limited, which may include, for example, ferrite and neodymium. The magnet may have any shape, which includes many shapes such as a rectangular ring shape with respect to the quadrangular prism. In order to easily engage the convex part 3211 with the concave part 3221, the outer circumferential surface of the convex part 3211 and the inner circumferential surface of the concave part 3221 may be made of a slippery material, or may have a gap therebetween. Any member may be interposed between the convex part 3211 and the concave part 3221. The permanent magnet may be embedded in the bottom surface of the concave part 3221. Any material may be used for the respective members, provided that parts on which the magnet acts are made of materials attracted to the magnet (such as iron, nickel and stainless). Any other configurations similar to the above embodiments are also embraced in the scope of the present invention.

### Reference Signs List

- 1: Circular knitting machine
- 2: Knitting unit
- 3: Take-up unit
- 31: Pull roller
- 32: Take-up roller
- 321: First take-up roller
- 322: Second take-up roller
- 3211: Convex part
- 3221: Concave part
- 32111: First facing part
- 32211: Second facing part
- 33: Magnet

## Claims

1. A split type take-up roller of a take-up unit (3) collecting knitted fabric knitted by a knitting unit (2) of a circular knitting machine (1), the split type take-up roller being horizontally provided, and collecting the knitted fabric by rolling up the knitted fabric thereon,
the split type take-up roller further comprising
a first take-up roller (321) and a second take-up roller (322) made by splitting the split type take-up roller in a substantial middle thereof in a longitudinal direction;
a first facing part (32111) being a facing part of the first take-up roller (321) so as to face the second take-up roller (322) in a state in which the first take-up roller (321) and the second take-up roller (322) are engaged with each other;
a second facing part (32211) being a facing part of the second take-up roller (322) so as to face the first facing part (32111) in the state in which the first take-up roller (321) and the second take-up roller (322) are engaged with each other;
the split type take-up roller being **characterized by** further comprising:
a magnet (33) provided on at least one of the first facing part (32111) and the second facing part (32211); and
a magnetic material on which magnetic force of the magnet acts, the magnetic material forming at least a part of the other one of the first facing part (32111) and the second facing part (32211) on which the magnet (33) is provided.

2. The split type take-up roller according to claim 1, wherein
the first take-up roller (321) includes a convex part (3211) protruding toward the second take-up roller (322) from a dividing surface that passes through a dividing position along a cross section perpendicular to the rotational axis and to the longitudinal direction of the first take-up roller (321) and the second take-up roller (322), and
the second take-up roller (322) includes a concave part (3221) having a shape to house the convex part (3211) therein.

3. The split type take-up roller according to claim 2, wherein
the convex part (3211) is constituted of at least one column, and the concave part (3221) is constituted of at least one columnar hole substantially complementarily formed such that the at least one column is inserted thereinto.

4. The split type take-up roller according to claim 2, wherein
in a state in which the split type take-up roller is not split, the first facing part (32111) is disposed on an end of the convex part (3211) at the side of the second take-up roller (322), and the magnet (33) is provided on at least a part of a surface of the second facing part (32211) or on a part inside the second facing part (32211).

## Patentansprüche

1. Geteilte Aufnahmerolle für eine Aufnahmeeinheit (3), die Maschenware aufnimmt, die von einer Strickeinheit (2) einer Rundstrickmaschine (1) gestrickt wurde, wobei die geteilte Aufnahmerolle horizontal bereitgestellt ist und die Maschenware aufnimmt, indem sie die Maschenware darauf aufrollt,
wobei die geteilte Aufnahmerolle weiter umfasst
eine erste Aufnahmerolle (321) und eine zweite Aufnahmerolle (322), die durch Teilen der geteilten Aufnahmerolle in einer wesentlichen Mitte davon in einer Längsrichtung hergestellt sind;
ein erstes zugewandtes Teil (32111), das ein zugewandtes Teil der ersten Aufnahmerolle (321) ist, so dass es der zweiten Aufnahmerolle (322) in einem Zustand zugewandt ist, in dem die erste Aufnahmerolle (321) und die zweite Aufnahmerolle (322) miteinander in Eingriff stehen;
wobei ein zweites zugewandtes Teil (32211) ein zugewandtes Teil der zweiten Aufnahmerolle (322) ist, so dass es dem ersten zugewandten Teil (32111) in dem Zustand zugewandt ist, in dem die erste Aufnahmerolle (321) und die zweite Aufnahmerolle (322) miteinander in Eingriff stehen;
wobei die geteilte Aufnahmerolle **dadurch gekennzeichnet ist, dass** sie weiter umfasst:
einen Magneten (33), der an mindestens einem von dem ersten zugewandten Teil (32111) und dem zweiten zugewandten Teil (32211) bereitgestellt ist; und
ein magnetisches Material, auf das magnetische Kraft des Magneten wirkt, wobei das magnetische Material zumindest einen Teil des anderen von dem ersten zugewandten Teil (32111) und dem zweiten zugewandten Teil (32211) bildet, auf dem der Magnet (33) bereitgestellt ist.

2. Geteilte Aufnahmerolle nach Anspruch 1, wobei
die erste Aufnahmerolle (321) einen konvexen Teil (3211) einschließt, der in Richtung der zweiten Aufnahmerolle (322) von einer Trennfläche vorsteht, die durch eine Trennposition entlang eines Querschnitts senkrecht zur Drehachse und zur Längsrichtung der ersten Aufnahmerolle (321) und der zweiten Aufnahmerolle (322) verläuft, und
die zweite Aufnahmerolle (322) einen konkaven Teil (3221) einschließt, der eine Form aufweist, um den konvexen Teil (3211) aufzunehmen.

3. Geteilte Aufnahmerolle nach Anspruch 2, wobei
der konvexe Teil (3211) aus mindestens einer Säule gebildet ist, und der konkave Teil (3221) aus mindestens einem säulenförmigen Loch gebildet ist, das im Wesentlichen komplementär geformt ist, so dass die mindestens eine Säule darin eingefügt wird.

4. Geteilte Aufnahmerolle nach Anspruch 2, wobei
in einem Zustand, in dem die geteilte Aufnahmerolle nicht geteilt ist, der erste zugewandte Teil (32111) an einem Ende des konvexen Teils (3211) an der Seite der zweiten Aufnahmerolle (322) angeordnet ist, und der Magnet (33) auf zumindest einem Teil einer Oberfläche des zweiten zugewandten Teils (32211) oder auf einem Teil innerhalb des zweiten zugewandten Teils (32211) bereitgestellt ist.

## Revendications

1. Rouleau d'enroulement de type fendu d'une unité d'enroulement (3) recueillant du tissu tricoté qui a été tricoté par une unité de tricotage (2) d'une machine à tricoter circulaire (1), le rouleau d'enroulement de type fendu étant prévu horizontalement et recueillant le tissu tricoté par enroulement du tissu tricoté sur lui,
le rouleau d'enroulement de type fendu comprenant en outre
un premier rouleau d'enroulement (321) et un second rouleau d'enroulement (322) constitués par fendage du rouleau d'enroulement de type fendu sensiblement en son milieu dans une direction longitudinale ;
une première partie de face (32111) étant une partie de face du premier rouleau d'enroulement (321) de manière à faire face au second rouleau d'enroulement (322) dans un état dans lequel le premier rouleau d'enroulement (321) et le second rouleau d'enroulement (322) sont en prise l'un avec l'autre ;
une seconde partie de face (32211) étant une partie de face du second rouleau d'enroulement (322) de manière à faire face à la première partie de face (32111) dans un état dans lequel le premier rouleau d'enroulement (321) et le second rouleau d'enroulement (322) sont en prise l'un avec l'autre ;
le rouleau d'enroulement de type fendu étant **caractérisé en ce qu'**il comprend en outre :
un aimant (33) prévu sur au moins l'une de la première partie de face (32111) et la seconde partie de face (32211) ; et
un matériau magnétique sur lequel une force magnétique de l'aimant agit, le matériau magnétique formant au moins une partie de l'autre de la première partie de face (32111) et de la seconde partie de face (32211) sur laquelle l'aimant (33) est prévu.

2. Rouleau d'enroulement de type fendu selon la revendication 1, dans lequel
le premier rouleau d'enroulement (321) inclut une partie convexe (3211) faisant saillie vers le second rouleau d'enroulement (322) à partir d'une surface de division qui passe à travers une position de division le long d'une section transversale perpendiculaire à l'axe de rotation et à la direction longitudinale du premier rouleau d'enroulement (321) et du second rouleau d'enroulement (322), et
le second rouleau d'enroulement (322) comporte une partie concave (3221) ayant une forme pour loger la partie convexe (3211) à l'intérieur de celle-ci.

3. Rouleau d'enroulement de type fendu selon la revendication 2, dans lequel
la partie convexe (3211) est constituée d'au moins une colonne et la partie concave (3221) est constituée d'au moins un trou en colonne formé de manière sensiblement complémentaire de telle sorte que l'au moins une colonne est insérée dans celui-ci.

4. Rouleau d'enroulement de type fendu selon la revendication 2, dans lequel
dans un état dans lequel le rouleau d'enroulement de type fendu n'est pas fendu, la première partie de face (32111) est disposée sur une extrémité de la partie convexe (3211) sur le côté du second rouleau d'enroulement (322), et l'aimant (33) est prévu sur au moins une partie d'une surface de la seconde partie de face (32211) ou sur une partie à l'intérieur de la seconde partie de face (32211).
